# EUROPÄISCHE PATENTSCHRIFT

(11) **EP 3 930 013 B1**
(45) Veröffentlichungstag und Bekanntmachung des Hinweises auf die Patenterteilung: **31.01.2024**
(21) Anmeldenummer: 21191337.1
(22) Anmeldetag: 22.09.2014
(51) Int. Cl.: H01L 31/18, H01L 21/30, H01L 21/266, H01L 31/0216, H01L 31/0224, H01L 31/0368, H01L 31/072, H01L 31/0745, H01L 31/0747

(54) **VERFAHREN ZUM HERSTELLEN EINER PHOTOVOLTAISCHEN SOLARZELLE MIT ZUMINDEST EINEM HETEROÜBERGANG**
METHOD FOR PRODUCING A PHOTOVOLTAIC SOLAR CELL WITH AT LEAST ONE HETEROJUNCTION
PROCÉDÉ DE FABRICATION D'UNE CELLULE SOLAIRE PHOTOVOLTAÏQUE DOTÉE D'AU MOINS UNE HÉTÉROJONCTION

(30) Priorität: 27.09.2013 DE 102013219561
(43) Veröffentlichungstag der Anmeldung: 29.12.2021
(62) Teilanmeldung aus: 14771325.9
(73) Patentinhaber: Fraunhofer-Gesellschaft zur Förderung der angewandten Forschung e.V., 80686 München (DE)
(72) Erfinder: FELDMANN, Frank, 79104 Freiburg (DE)
(74) Vertreter: LBP Lemcke, Brommer & Partner Patentanwälte mbB

(56) Entgegenhaltungen:
- WO-A1-2011/050399
- US-A1- 2013 122 640
- HONG SEUNG ET AL: "Doping- and size-dependent photovoltaic properties of p-type Si-quantum-dot heterojunction solar cells: correlation with photoluminescence", APPLIED PHYSICS LETTERS, AMERICAN INSTITUTE OF PHYSICS, 2 HUNTINGTON QUADRANGLE, MELVILLE, NY 11747, Bd. 97, Nr. 7, 17. August 2010 (2010-08-17), Seiten 72108-72108, XP012138810, ISSN: 0003-6951, DOI: 10.1063/1.3480609
- SONG ET AL: "Structural, electrical and photovoltaic characterization of Si nanocrystals embedded SiC matrix and Si nanocrystals/c-Si heterojunction devices", SOLAR ENERGY MATERIALS AND SOLAR CELLS, ELSEVIER SCIENCE PUBLISHERS, AMSTERDAM, NL, Bd. 92, Nr. 4, 30. Januar 2008 (2008-01-30), Seiten 474-481, XP022440288, ISSN: 0927-0248, DOI: 10.1016/J.SOLMAT.2007.11.002
- KAFLE B ET L: "Thermal stability investigations of PECVD Al2O3 films discussing a possibility of improving surface passivation by re-hydrogenation after high temperature processes", PROCEEDINGS OF THE 27TH EUROPEAN PHOTOVOLTAIC SOLAR ENERGY CONFERENCE, 24. September 2012 (2012-09-24), - 28. September 2012 (2012-09-28), Seiten 1788-1792, XP040634063, ISBN: 978-3-936338-28-7

## Beschreibung

Eine photovoltaische Solarzelle stellt ein flächiges Halbleiterbauelement dar, bei welchem durch Absorption einfallender elektromagnetischer Strahlung Ladungsträgerpaare erzeugt und anschließend an einem pn-Übergang getrennt werden, so dass zwischen mindestens zwei elektrischen Kontaktpunkten der Solarzelle ein Potential entsteht und elektrische Leistung abgegriffen werden kann.

Der pn-Übergang kann dadurch realisiert sein, dass in einem Halbleitersubstrat mit einer Basisdotierung mittels Diffusion eines Dotierstoffes einer zu der Basisdotierung entgegengesetzten Emitterdotierung ein entsprechender Emitterbereich ausgebildet wird, so dass zwischen Emitterbereich und basisdotiertem Bereich des Halbleitersubstrates ein pn-Übergang entsteht.

Ebenso ist es bekannt, den Emitter durch Aufbringen einer oder mehrerer Schichten auf ein Basissubstrat auszubilden, insbesondere durch Aufbringen einer Emitterschicht aus amorphem Silizium auf einem Basissubstrat bestehend aus monokristallinem Silizium. Die Emitterschicht weist auch hier einen zu der Basis entgegengesetzten Dotierungstyp auf, so dass sich zwischen Emitter und Basis ein pn-Übergang ausbildet. Da die amorphe Siliziumschicht des Emitters gegenüber dem kristallinen Silizium der Basis eine unterschiedliche Bandlücke aufweist, bildet sich ein so genannter Hetero-pn-Übergang aus, so dass ein so genannter Heteroemitter vorliegt.

Sofern Basissubstrat und amorphe Siliziumschicht den gleichen Dotierungstyp, jedoch unterschiedliche Dotierkonzentrationen aufweisen, entsteht ebenfalls ein Heteroübergang, in diesem Fall eine sogenannte "High-Low-Junction". Ein solcher Heteroübergang wird zur Ausbildung von Heterokontakten verwendet:
Auch bei der Kontaktierung der Halbleiterbereiche sind unterschiedliche physikalische Kontaktarten bekannt: Typischerweise wird eine metallische Kontaktierungsstruktur mittelbar oder unmittelbar auf den zu kontaktierenden Halbleiterbereich aufgebracht. Hierbei ist insbesondere die Ausbildung eines Ohmschen Kontaktes und eines Schottky-Kontaktes bekannt. Ebenfalls als spezielle Ausbildung eines Hetero-Kontaktes sind auch MOS/MIS-Kontakte bekannt. Eine spezielle Ausführung von MOS/MIS Kontakten ist folgender Aufbau, Substrat/Tunneloxid/dotierte poly-Si-Schicht. Solche Kontaktarten sind bei Halbleitern bekannt und beispielsweise beschrieben in Peter Würfel, Physics of Solar Cells: From Principles to New Concepts. 2005, Weinheim: Wiley-VCH. (Hetero-Kontakt: Kapitel 6.6, S. 127ff; Schottky-Kontakt: Kapitel 6.7.1, S. 131f; MIS-Kontakt: Kapitel 6.7.2, S.132) und Sze, S.M., Semiconductor devices: Physics and Technology. 1985, New York: John Wiley & sons.(MOS-Kontakt: Kapitel 5.4, S.186; Metall-Halbleiterkontakt: Kapitel 5.1, S. 160ff.).

Heteroübgergänge werden klassischerweise als Übergänge von Materialien unterschiedlicher Bandlücke bezeichnet. Heterokontakte können aber auch unter Anordnung einer Tunnelschicht zwischen Halbleitersubstrat und Heteroübergangsschicht ausgebildet sein, beispielsweise als Substrat/Tunneloxid/ Siliziumhaltige Schicht bzw. MIS-Kontakte wie zuvor beschrieben. Die Bezeichnung "Heteroübergang" wird in dieser Anmeldung in diesem umfassenden Sinn verwendet. Die "Hetero"-Eigenschaft des Heteroübergangs kann somit in einer unterschiedlichen Bandlücke zwischen Halbleitersubstrat und Heteroübergangsschicht und/oder zwischen Tunnelschicht und Heteroübergangsschicht begründet sein.

Die Bezeichnung "Heteroübergang" umfasst in dieser Anmeldung wie eingangs bereits erwähnt sowohl Übergänge mit Schichten unterschiedlicher Dotierungstypen, insbesondere zur Ausbildung von Heteroemittern, als auch Übergänge mit Schichten gleicher Dotierungstypen, insbesondere zur Ausbildung von Heterokontakten.

Analog zu der hinsichtlich der Emitter eingeführten Definition werden vorliegend solche Kontakte, die keine Heterokontakte sind, als Homokontakte bezeichnet
Photovoltaische Solarzellen, die einen Heteroemitter und/oder einen Heterokontakt aufweisen, d. h. mindestens einen Heteroübergang, werden als Heterosolarzellen bezeichnet. Solche Heterosolarzellen sind beispielsweise aus DE 10 2008 030 693 A1 und US 2012/0055547 A1 bekannt.

Aus US 2013/203210 geht ein Verfahren zum Herstellen einer Solarzelle hervor, umfassend das Erzeugen eines Heteroübergangs an einer Seite eines Halb-leitersubstrats, welcher Heteroübergang eine dotierte Heteroübergangsschicht und eine unmittelbar zwischen Heteroüberhangsschicht und Halbleitersubstrat angeordnete dielektrische Tunnelschicht aufweist. In einem weiteren Verfahrensschritt wird der Heteroübergang in einer WasserstoffAtmosphäre auf weniger als 200°C erwärmt.

Aus US 2013/122640 A1 ist ein Es ein Herstellungsverfahren für eine quantenpunktsensibilisierte Halbleitersolarzelle bekannt. Das Herstellungsverfahren weist folgende Schritte auf: einen Schritt zur Bildung eines Quantenpunkts, bei dem eine Halbleiterschicht, die ein Element der Gruppe 4 und InP enthält, auf einem Substrat gebildet wird, und dann eine Wärmebehandlung des Substrats einschließlich der darauf gebildeten Halbleiterschicht durchgeführt wird, um Indium (In) daraus zu entfernen, wodurch ein Halbleiterquantenpunkt vom n-Typ gebildet wird, der ein mit Phosphor (P) dotierter Quantenpunkt der Gruppe 4 ist.

Aus Hong Seung et al. "Doping- and size-dependent photovoltaic properties of p-type Si-quantum-dot heterojunction solar cells: correlation with photoluminescence", doi: 10.1016/j.solmat.2007.11.002 ist ein Verfahren bekannt, um mit Bor dotierte SiOx/SiO2-Supergitter durch lonenstrahlsputtern auf n-Typ-Si(100)-Wafern herzustellen. Durch ein anschließendes Tempern werden p-Typ-Si-Quantenpunkte (QDs)/n-Typ-Si-Wafer-Heteroübergangssolarzellen gebildet.

Aus DengyuanSong et al., "Structural, electrical and photovoltaic characterization of Si nanocrystals embedded SiC matrix and Si nanocrystals/c-Si heterojunction devices", doi: 10.1016/j.solmat.2007.11.002, ist es bekannt, dünne Schichten aus Si-Nanokristallen (Si-NCs), die in eine Siliziumkarbid (SiC)-Matrix (Si-NC:SiC) eingebettet sind, durch abwechselnde Abscheidung von Si-reichem Siliziumkarbid (Si1-xCx) und nahezu stöchiometrischen SiC-Mutilayern (Si1-xCx/SiC) mittels Magnetron-Cosputtering und anschließender Glühung herzustellen.

Der vorliegenden Erfindung liegt die Aufgabe zugrunde die vorbekannten Verfahren zur Herstellung von Heterosolarzellen zu verbessern.

Gelöst ist diese Aufgabe durch ein Verfahren gemäß Anspruch 1. Vorzugsweise Ausgestaltungen des erfindungsgemäßen Verfahrens finden sich in den abhängigen Ansprüchen, welche hiermit explizit per Referenz in die Beschreibung einbezogen werden.

Das erfindungsgemäße Verfahren zum Herstellen einer photovoltaischen Solarzelle mit mindestens einem Heteroübergang, welcher eine Tunnelschicht aufweist, umfasst folgende Verfahrensschritte:
In einem Verfahrensschritt A erfolgt ein Bereitstellen eines Halbleitersubstrates mit einer Basisdotierung.

In einem Verfahrensschritt B wird ein Heteroübergang an zumindest einer Seite des Halbleitersubstrates erzeugt. Der Heteroübergang wird eine dotierte Heteroübergangsschicht und eine unmittelbar zwischen Heteroübergangsschicht und Halbleitersubstrat angeordnete dielektrische Tunnelschicht aufweisend ausgebildet. Die Tunnelschicht ist vorzugsweise undotiert (intrinsisch) ausgebildet.

In einem Verfahrensschritt C erfolgt ein Erwärmen der Heteroübergangsschicht auf zumindest 600°C zum Verbessern der elektrischen Güte des Heteroübergangs.

Es ist bekannt, dass bei Heteroübergängen mit dielektrischer Tunnelschicht eine Aktivierung durch Erwärmen die Güte des Heteroübergangs verbessern kann. Durch das Erwärmen verringert sich die Ladungsträgerrekombination, so dass im Ergebnis mit einem wärmebehandelten Heteroübergang in der Regel eine höhere Offenklemmspannung der Solarzelle erzielt wird. In Verfahrensschritt C erfolgt somit eine Erwärmung zumindest derart, dass eine dem Heteroübergang zugeordnete effektive Oberflächenrekombinationsgeschwindigkeit zumindest für die Minoritätsladungsträger an der dem Heteroübergang zugewandten Seite des Halbleitersubstrates verringert wird.

Wesentlich ist, dass in einem Verfahrensschritt D nach Verfahrensschritt C Wasserstoff in die Heteroübergangsschicht und/oder an die Grenzfläche zwischen Tunnelschicht und Halbleitersubstrat eindiffundiert wird, wobei im besagtem Verfahrensschritt D die Solarzelle auf zumindest 350°C erwärmt wird. Auf der Heteroübergangsschicht wird mittelbar eine metallische Kontaktierungsschicht angeordnet, welche elektrisch leitend mit der Heteroübergangsschicht zur Ausbildung einer Kontaktierung verbunden wird.

Die Heteroübergangsschicht wird mit einer Dicke im Bereich 10 nm bis 1000 nm ausgebildet.

Die Erfindung ist in der überraschenden Erkenntnis begründet, dass durch Hinzufügen des Verfahrensschrittes D mit Eindiffundieren von Wasserstoff zumindest in die Heteroübergangsschicht und/oder an die Grenzfläche zwischen Tunnelschicht und Halbleitersubstrat eine erhebliche Verbesserung der vorbekannten Verfahren zum Herstellen einer photovoltaischen Solarzelle mit mindestens einem Heteroübergang erzielt wird: Durch Eindiffundieren von Wasserstoff wie zuvor beschrieben kann zum einen eine Erhöhung der Offenklemmspannung gegenüber vorbekannten Verfahren erzielt werden. Darüber hinaus ist in Verfahrensschritt C ein erheblich breiterer Parameterbereich hinsichtlich des Erwärmens der Heteroübergangsschicht möglich, ohne dass erhebliche Einbußen hinsichtlich der Offenklemmspannung auftreten. Ein möglicherweise nur teilweises oder unvorteilhaftes Aktivieren der Heteroübergangsschicht in Verfahrensschritt C wird somit zumindest hinsichtlich der Offenklemmspannung durch den Verfahrensschritt D des erfindungsgemäßen Verfahrens kompensiert und darüber hinaus ist sogar insgesamt eine Erhöhung der Offenklemmspannung gegenüber vorbekannten Verfahren möglich.

Das erfindungsgemäße Verfahren ermöglicht somit breitere Prozessfenster hinsichtlich der Parameter wie beispielsweise Temperatur, Temperaturkonstanz und Dauer der Wärmebeaufschlagung in Verfahrensschritt C, ebenso aber auch hinsichtlich von Materialparametern betreffend beispielsweise die Güte der Tunnelschicht und/oder der Heteroübergangsschicht. Mittels des erfindungsgemäßen Verfahrens bestehen somit mehr Freiheiten oder Toleranzen hinsichtlich des Prozessablaufs und/oder die Solarzelle wird hinsichtlich ihrer Offenklemmspannung verbessert.

Eine weitere Verbesserung der Offenklemmspannung und/oder Verbreiterung der vorgenannten Prozessfenster wird erzielt, indem in einer vorzugsweisen Ausführungsform in Verfahrensschritt D nach Verfahrensschritt C Wasserstoff weiterhin sowohl an die Grenzfläche zwischen Tunnelschicht und Halbleitersubstrat, als auch in die Heteroübergangsschicht eindiffundiert wird.

Das erfindungsgemäße Verfahren ist insbesondere zur Verwendung einer kohlenstoffhaltigen Siliziumcarbitschicht (SiC-Schicht) geeignet. In einer vorteilhaften Ausführungsform wird daher in Verfahrensschritt B die Heteroübergangsschicht als SiC-Schicht, insbesondere einer dotierten SiC-Schicht ausgebildet.

Die Verwendung einer SiC-Schicht als Heteroübergangsschicht ist an sich bekannt und in US 2012/0055547 A1 beschrieben. Eine solche Schicht weist gegenüber anderen vorbekannten Heteroübergangsschichten, wie beispielsweise Heteroübergangsschichten aus amorphem, hydrogenisiertem Silizium (a-Si:H) den Vorteil auf, dass eine größere Temperaturstabilität gegeben ist, so dass eine größere Freiheit hinsichtlich der Prozessschritte nach Aufbringen der Heteroübergangsschicht insbesondere bezogen auf die verwendeten Temperaturen gegeben ist.

Aufwändige Experimente haben gezeigt, dass insbesondere solche SiC-Schichten zum Aktivieren, d. h. zum Erzielen einer ausreichend hohen elektrischen Güte für eine hohe Offenklemmspannung in Verfahrensschritt C eine Erwärmung auf eine hohe Temperatur benötigen und darüber hinaus die positiven Effekte nur in einem engen Prozessfenster, insbesondere bei einem engen Temperaturfenster auftreten.

Durch das erfindungsgemäße Verfahren ist es möglich, eine SiC-Schicht als Heteroübergangsschicht zu verwenden, ohne dass die bei vorbekannten Verfahren engen Prozessfenster in Verfahrensschritt C eingehalten werden müssen. Ebenso liegen andere Heteroübergangsschichten im Rahmen der Erfindung, insbesondere die Ausbildung der Heteroübergangsschicht als amorphe Siliziumschicht (a-Si), amorphe Siliziumoxidschicht (a-SiOx) oder amorphe Siliziumnitridschicht (a-SiNₓ). Hierbei weist die Schicht bevorzugt einen Siliziumanteil von zumindest 70 %, insbesondere zumindest 80 % auf. Ebenso liegt die Ausbildung der Heteroübergangsschicht als polykristalline Siliziumschicht oder amorphe/mikrokristalline/polykristalline Siliziumcarbitschicht (a-SiC/µc-SiC/pc-SiC) im Rahmen der Erfindung.

Ebenso liegt es im Rahmen der Erfindung, die Heteroübergangsschicht n-dotiert oder p-dotiert auszubilden.

Die größere Bandbreite der in Verfahrensschritt C sinnvoll anwendbaren Temperaturen bei dem Erwärmen der Heteroübergangsschicht ermöglicht darüber hinaus eine breitere Auswahl hinsichtlich der Ausgestaltung der dielektrischen Tunnelschicht. Insbesondere die Verwendung einer siliziumoxidbasierten Tunnelschicht, wie beispielsweise einer SiO₂-Tunnelschicht war bei vorbekannten Verfahren kritisch, da eine solche Tunnelschicht bei Temperaturen größer 900 °C beschädigt wird, so dass der Wirkungsgrad der Solarzelle verringert wird. Bei vorbekannten Verfahren war es jedoch notwendig, die als SiC-Schicht ausgebildete Heteroschicht bei Temperaturen im Bereich von 900 °C zu aktivieren, so dass hier ein erhebliches Risiko in Kombination insbesondere mit der Verwendung von siliziumoxidbasierten Tunnelschichten bestand. Bei dem erfindungsgemäßen Verfahren sind jedoch auch niedrigere Temperaturen in Verfahrensschritt C möglich, so dass wiederum mit einem erheblich geringeren Risiko die Verwendung anderer Tunnelschichten wie beispielsweise einer siliziumoxidbasierten Tunnelschicht oder einer der Schichten HfO₂-Schicht, Al₂O₃-Schicht, AIN-Schicht, AlSiOₓ-Schicht, HfSiOₓ-Schicht möglich ist.

In einer vorzugsweisen Ausführungsform erfolgt daher in Verfahrensschritt C eine Erwärmung auf eine Temperatur kleiner 900 °C, bevorzugt kleiner 880 °C, insbesondere bevorzugt kleiner 850 °C, um eine Beschädigung der Tunnelschicht zu vermeiden.

Untersuchungen haben gezeigt, dass in Verfahrensschritt C ein Erwärmen zumindest der Heteroübergangsschicht, bevorzugt der gesamten Solarzelle, auf zumindest 600 °C, bevorzugt auf zumindest 700 °C erfolgt. Dies führt zu einer vorteilhaften Erhöhung der Offenklemmspannung insbesondere bevorzugt in Kombination mit der Ausbildung der Heteroübergangsschicht als SiC-Schicht. Die Erwärmung kann mittels RTP (rapid thermal processing) erfolgen. Hierbei erfolgt die Erwärmung bevorzugt vorzugsweise für eine Zeitdauer von zumindest 3s, bevorzugt 10s, bevorzugt im Bereich zwischen 3s und 1 Minute. Ebenso kann die Erwärmung in einem Ofen, insbesondere Rohrofen erfolgen. Die Erwärmung erfolgt hierbei vorzugsweise für eine Zeitdauer von zumindest 10 Minuten, bevorzugt 60 Minuten, insbesondere bevorzugt im Bereich 10 Minuten bis 120 Minuten.

Insbesondere bei der Verwendung einer SiC-Schicht als Heteroübergangsschicht ist somit bei dem erfindungsgemäßen Verfahren in Verfahrensschritt C ein Prozessfenster hinsichtlich der Temperaturen zumindest im Bereich 600 °C bis 900 °C, bevorzugt im Bereich 700 °C bis 880 °C gegeben, in welchem eine erhebliche Erhöhung der Offenklemmspannung erzielt wird. Dies ist insbesondere eine Verbesserung gegenüber vorbekannter Verfahren mit Verwendung einer SiC-Heteroübergangsschicht, welche zwingend eine Temperatur im Bereich 900 °C benötigen.

In Verfahrensschritt D wird wie zuvor beschrieben Wasserstoff zumindest in die Heteroübergangsschicht und/oder an die Grenzfläche zwischen Tunnelschicht und Halbleitersubstrat eindiffundiert. Dies erfolgt durch Erwärmen der Solarzelle auf zumindest 350 °C. Untersuchungen haben gezeigt, dass ab dieser Temperatur ein ausreichend hohes Eindiffundieren von Wasserstoff erfolgt. Das Erwärmen erfolgt vorzugsweise zumindest für eine Zeitdauer von 1 min, bevorzugt 10 min, bevorzugt 30 min.

Vorzugsweise erfolgt in Verfahrensschritt D ein Erwärmen auf eine Temperatur kleiner 800 °C, insbesondere kleiner 600 °C, um eine Beeinträchtigung der elektrischen Güte der Schichten der Solarzelle zu vermeiden. Ein Aktivieren bzw. teilweises Aktivieren kann bereits in Verfahrensschritt C erfolgen, so dass vorzugsweise in Verfahrensschritt D eine Temperatur unterhalb der Aktivierungstemperatur, bevorzugt kleiner 600 °C gewählt wird.

In einer vorteilhaften Ausführungsform des erfindungsgemäßen Verfahrens wird die Heteroübergangsschicht als amorphe Siliziumschicht, insbesondere bevorzugt als amorphe Siliziumcarbidschicht (a-SiC) ausgebildet. Der amorphe Charakter einer Heteroübergangsschicht, insbesondere einer dotierten SiC-Schicht ist vorteilhaft für die Effizienz des Heterokontakts. Vorzugsweise erfolgt daher in den Verfahrensschritten C und D ein zumindest teilweises, vorzugsweises vollständiges Erhalten der amorphen Struktur der Heteroübergangsschicht. Bei typischen a-SiC Schichten wird die amorphe Struktur zumindest teilweise erhalten, in dem keine Erwärmung der Heteroübergangsschicht auf über 850 °C, bevorzugt keine Erwärmung auf über 700 °C erfolgt. Untersuchungen zeigten, dass insbesondere eine Erwärmung auf eine Temperatur im Bereich 780°C bis 820°C, insbesondere etwa 800°C vorteilhaft hinsichtlich der elektrischen Passivierungswirkung ist.

Mit dem erfindungsgemäßen Verfahren ist es somit insbesondere bei Ausbildung der Heteroübergangsschicht als SiC-Schicht erstmals möglich, eine hohe elektrische Güte des Heteroübergangs zu erzielen und dennoch eine amorphe Struktur der Heteroübergangsschicht zu erhalten.

Bei dieser vorzugsweisen Ausführungsform ist es vorteilhaft, die Heteroübergangsschicht als dotierte Heteroübergangsschicht auszubilden, da aufgrund der Temperaturen in dem Verfahrensschritt C und D kleiner 800 °C, bevorzugt kleiner 700 °C keine oder nur eine geringfügige Diffusion von Dotierstoffen aus der Heteroübergangsschicht in das Halbleitersubstrat erfolgt. Es wird somit in vorteilhafterweise ein so genannter abrupter Heteroübergang (ohne Diffusionseintrag in das Substrat) ausgebildet. Mit abrupten Heteroübergängen sind höchsteffiziente Solarzellen ausgebildet worden, sie stellen somit eine vorteilhafte Ausgestaltung für sehr hohe Wirkungsgrade dar.

Das Bereitstellen des Wasserstoffs in Verfahrensschritt D zum Eindiffundieren zumindest in die Heteroübergangsschicht und/oder die Grenzfläche zwischen Tunnelschicht und Halbleitersubstrat kann auf unterschiedliche Weise erfolgen:
In einer vorzugsweisen Ausführungsform wird in Verfahrensschritt D ein Tempern in einer atomaren Wasserstoffatmosphäre durchgeführt, bevorzugt bei einer Temperatur von etwa 400 °C.

Insbesondere wird der Wasserstoff bevorzugt in Verfahrensschritt D mittels eines Remote Plasma Hydrogen Passivation (RPHP)-Verfahrens eingebracht. Das RPHP-Verfahren ist an sich bekannt und beispielsweise in S. Lindekugel, et al.,"Plasma hydrogen passivation for crystalline silicon thin-films," in Proceedings of the 23rd European Photovoltaic Solar Energy Conference, Valencia, Spain, 2008, pp. 2232-5 beschrieben. Dieses Verfahren ist auch unter der Abkürzung MIRP (Microwave Induced Remote Plasma) bekannt.

Eine Verwendung dieser Verfahren bietet den Vorteil, dass ein effizientes Einbringen von Wasserstoff in Verfahrensschritt D gewährleistet ist und gleichzeitig keine Erwärmung auf eine Temperatur über 600 °C notwendig ist, so dass insbesondere eine amorphe Struktur der Heteroübergangsschicht erhalten werden kann und keine oder nur geringfügig eine Diffusion von Dotierstoffen aus der Heteroübergangsschicht in das Halbleitersubstrat erfolgt.

Alternativ oder zusätzlich kann in Verfahrensschritt D Wasserstoff eingebracht werden, in dem in einer bevorzugten Ausführungsform eine wasserstoffhaltige Schicht mittelbar oder bevorzugt unmittelbar auf die Heteroübergangsschicht aufgebracht und anschließend mittels Erwärmung auf mindestens 350 °C der Wasserstoff eingebracht wird.

Hierbei wird somit die wasserstoffhaltige Schicht mittelbar oder bevorzugt unmittelbar auf die dem Halbleitersubstrat abgewandten Seite der Heteroübergangsschicht aufgebracht und mittels Erwärmen der Wasserstoff aus der wasserstoffhaltigen Schicht eindiffundiert. Auch hierbei kann die Temperatur in Verfahrensschritt D bevorzugt kleiner 600 °C, insbesondere bevorzugt kleiner 500 °C sein, um die zuvor benannten Vorteile hinsichtlich des Erhaltens einer amorphen Struktur der Heteroübergangsschicht und des Vermeidens des Eindiffundierens von Dotierstoffen aus der Heteroübergangsschicht in das Halbleitersubstrat zu erzielen.

In einer vorzugsweisen Ausführungsform ist die zuvor genannte wasserstoffhaltige Schicht als mikrokristalline Siliziumschicht, insbesondere als hydrogenisierte mikrokristalline Siliziumcarbidschicht (µc-SiC:H) ausgebildet. Hierdurch ergibt sich der Vorteil, dass diese Schicht leitfähiger und optisch transparenter als beispielsweise eine a-Si:H-Schicht ist. Insbesondere kann ein µc-SiC-Schicht vorteilhafterweise als transparente Kontaktierung dienen und somit an sich bekannte leitfähige transparente Elektroden, beispielsweise TCO-Schichten ersetzen.

Ebenso kann die wasserstoffhaltige Schicht als Siliziumnitridschicht, insbesondere hydrogenisierte Siliziumnitridschicht ausgebildet sein. Hierbei erfolgt vorzugsweise in Verfahrensschritt D eine Erwärmung auf eine Temperatur im Bereich 700 °C bis 900 °C, jedoch lediglich für einen Zeitraum von wenigen Sekunden, insbesondere zwischen 1 Sekunde und 30 Sekunden, bevorzugt zwischen 1 Sekunde und 15 Sekunden. Hierdurch wird in besonders effizienter Weise in einem zeitunaufwändigen Verfahrensschritt Wasserstoff eindiffundiert. Aufgrund der kurzzeitigen Wärmebeaufschlagung wird eine Diffusion von Dotierstoff vermieden oder zumindest verringert.

Vorzugweise wird Verfahrensschritt C in Stickstoffatmosphäre durchgeführt. Hierdurch ergibt sich der Vorteil, dass die SiC-Schicht nicht oxidiert/geändert wird. Eine Oxidation von SiC würde sowohl die Leitfähigkeit als auch die elektrische Kontaktierbarkeit beeinträchtigen.

Auf der Heteroübergangsschicht wird mittelbar eine metallische Kontaktierungsschicht angeordnet, welche elektrisch leitend mit der Heteroübergangsschicht zur Ausbildung einer Kontaktierung verbunden ist.

Das erfindungsgemäße Verfahren bietet darüber hinaus den Vorteil, dass es nun erstmals möglich ist, die Passivierung von undotierten Heterokontakten zu aktivieren: Dies ist darin begründet, dass in Verfahrensschritt C die Passivierung von der Diffusion von Dotierstoffen beeinflusst wird: Dotierstoffe lagern sich an offenen Bindungen und/oder Korngrenzen an und reduzieren somit die Anzahl der Defekte. Des Weiteren wird während Verfahrensschritt C ein Dotierprofil im Halbleitersubstrat erzeugt, welches eine Reduzierung der Minoritätsladungsträgerdichte an der Grenzfläche Halbleitersubstrat/Tunnelschicht bewirkt, andererseits aber Rekombinationsverluste im Halbleitersubstrat (Augerrekombination) bedingt. Das Ausbilden eines Dotierprofils im Halbleitersubstrat ist insbesondere dann vorteilhaft, wenn die Qualität der Tunnelschicht hinsichtlich der Passivierung des Halbleitersubstrates nicht sichergestellt werden kann.

In einer vorzugsweisen Ausführungsform des erfindungsgemäßen Verfahrens wird somit die Heteroübergangsschicht in Verfahrensschritt B zumindest bereichsweise als undotierte Heteroübergangsschicht ausgebildet.

Insbesondere ist es vorteilhaft, in der Heteroübergangsschicht eine Mehrzahl alternierend angeordneter p- und n-dotierter Bereiche auszubilden, wobei die p- und n-dotierten Bereiche jeweils beabstandet voneinander erzeugt werden, so dass zwischen benachbarten p- und n-dotieren Bereichen jeweils ein nicht dotierter Bereich der Heteroübergangsschicht angeordnet ist.

Das erfindungsgemäße Verfahren wird somit vorteilhaft zur Ausbildung photovoltaischer Rückseitenkontaktzellen mit der zuvor beschriebenen Ausgestaltung angewendet:
Solche photovoltaischen Solarzellen umfassen ein typischerweise als Siliziumsubstrat ausgebildetes Halbleitersubstrat mit einer auf einer Rückseite des Halbleitersubstrats mittelbar oder unmittelbar angeordneten Tunnelschicht und einer auf der Tunnelschicht unmittelbar angeordneten Heteroübergangsschicht, welche bevorzugt als Siliziumschicht, insbesondere wie zuvor beschrieben als SiC-Schicht ausgebildet wird. Die Heteroübergangsschicht weist eine Mehrzahl alternierend angeordneter p- und n-dotierter Bereiche auf.

Photovoltaische Rückseitenkontaktzellen sind an sich bekannt und weisen beide Kontaktierungspolaritäten auf der bei Benutzung dem Lichteinfall abgewandten Rückseite der Solarzelle auf, sodass eine einfachere Verschaltung im Modul möglich ist und insbesondere an der Vorderseite es nicht notwendig ist, metallische Kontaktierungsstrukturen anzuordnen, sodass Abschattungsverluste durch solche metallischen Kontaktierungsstrukturen vermieden werden, da die metallischen Kontaktierungsstrukturen beider Polaritäten auf der Rückseite angeordnet werden können.

Die vorliegende vorteilhafte Ausgestaltung betrifft hierbei eine spezielle Ausgestaltung solch einer Rückseitenkontaktzelle, bei welcher auf dem Siliziumsubstrat eine Tunnelschicht und auf der Tunnelschicht unmittelbar eine Heteroübergangsschicht mit den alternierend, das heißt abwechselnd, angeordneten p- und n-dotierten Bereichen aufgebracht wird.

Derartige rückseitenkontaktierte photovoltaische Silizium-Solarzellen besitzen ein sehr hohes Wirkungsgradpotenzial, da sie wie zuvor beschrieben keine Abschattung auf der dem Lichteinfall zugewandten Vorderseite aufgrund metallischer Kontaktstrukturen aufweisen und rückseitig die Metallisierung unabhängig von optischen Einschränkungen optimiert werden kann. Bei vorbekannten rückseitenkontaktierten Silizium-Solarzellen mit in einem Halbleitersubstrat eindiffundierten Emittern ist die Ladungsträgerrekombination in diesem hochdotierten Bereich, insbesondere an den Bereichen welche mit Metallkontakten versehen sind, jedoch dominierend, sodass ein dotierter Emitter oder ein sogenanntes BSF, das heißt eine Hochdotierung des Basis-Dotierungstyps eine Limitierung der Offenklemmspannung der Solarzelle darstellt.

Es ist daher bekannt, den Wirkungsgrad dadurch zu erhöhen, dass zwar Emitter und BSF an der Rückseite der Solarzelle angeordnet sind, jedoch durch eine dünne dielektrische Tunnelschicht von dem Substrat abgetrennt sind; Es ergibt sich somit ein Hetero-Übergang. Hierdurch wird eine Dunkelsättigungsstromdichte verringert und es können somit vergleichsweise höhere Offenklemmspannungen erzielt werden. Eine solche Solarzelle ist beispielsweise in US 7,468,485 B1 beschrieben.

Zur Herstellung solch einer Solarzelle ist es aus der vorgenannten Schrift und ebenso aus US 2009/0308438 A1 sowie aus US 2010/0139764 A1 bekannt, auf die vorgenannte dielektrische Tunnelschicht eine polykristalline Siliziumschicht als Heteroübergangsschicht aufzubringen, anschließend die polykristalline Siliziumschicht zu strukturieren und nacheinander p- und n-Dotierstoffquellen aufzubringen. Weiterhin sind Verfahren zur Herstellung einer solchen Solarzellenstruktur aus WO 2012/039831 A1 bekannt.

Die mittels einer vorteilhaften Ausgestaltung des Verfahrens ausgebildete photovoltaische Solarzelle umfasst somit vorzugsweise ein Halbleitersubstrat mit einer auf einer Rückseite des Halbleitersubstrats unmittelbar angeordneten Tunnelschicht und einer auf der Tunnelschicht unmittelbar angeordneten Heteroübergangsschicht, welche Heteroübergangsschicht eine Mehrzahl alternierend angeordneter p- und n-dotierter Bereiche aufweist.

Hinsichtlich dieses Grundaufbaus entspricht die Ausbildung dieser Solarzelle somit den zuvor beschriebenen, aus dem Stand der Technik bekannten Solarzellenstrukturen. Es liegt im Rahmen der Erfindung, dass die Solarzelle weitere übliche Elemente, wie beispielsweise metallische Kontaktierungsstrukturen zur elektrischen Kontaktierung einerseits der p-dotierten Bereiche und andererseits der n-dotierten Bereiche aufweisend ausgebildet wird und/oder weitere Schichten und/oder Strukturierungen zur Erhöhung des Wirkungsgrades, insbesondere zur elektrischen Passivierung von Oberflächen, das heißt Verringerung der Oberflächenrekombinationsgeschwindigkeiten und/oder Erhöhung des Lichteinfalls oder der Lichtabsorption ausgebildet werden.

Wesentlich ist in dieser vorzugsweisen Ausführungsform, dass in der Heteroübergangsschicht zwischen den p-dotierten und n-dotierten Bereichen jeweils ein undotierter Bereich angeordnet wird.

Die vorzugsweise Ausführungsform des erfindungsgemäßen Verfahrens zur Ausbildung solch einer Solarzelle ist in der Erkenntnis des Anmelders begründet, dass ein erheblicher Verlustfaktor, der zu einer Wirkungsgradverringerung führen kann, an der Grenzfläche zwischen p- und n-dotierten Bereichen auftritt: An dieser Grenzfläche führen insbesondere die aus dem Stand der Technik bekannten Herstellungsverfahren zu einer erhöhten Rekombination, in der sich an diesen Grenzflächen ausbildenden Raumladungszone.

Diese Solarzelle bietet nun erstmals eine Solarzellenstruktur, die gleichzeitig eine kostengünstige Herstellung und dennoch eine Vermeidung der vorgenannten Verluste ermöglicht: Durch das Verwenden einer durchgängigen Heteroübergangsschicht, welche zwischen einem p-dotierten und einem n-dotierten Bereich jeweils einen zwischengeordneten undotierten Bereich aufweist, wird somit die Ausbildung der vorgenannten Raumladungszone in einfacher und kostengünstiger Weise vermieden und hierdurch der Wirkungsgrad der Solarzelle ohne eine wesentliche Erhöhung der Prozessierungskosten im Vergleich zu vorbekannten Verfahren bzw. im Vergleich zu Verfahren mit einer Reduzierung von Prozessierungskosten erzielt.

Der Vorteil ist insbesondere in der überraschenden Erkenntnis begründet, dass durch die zwischengeschalteten undotierten Bereiche der Heteroübergangsschicht einerseits wirksam das Ausbilden einer solchen Raumladungszone, die zu erhöhten Rekombinationsverlusten führt, unterbunden werden kann und andererseits kein oder nur ein unwesentlicher Wirkungsgradverlust durch die teilweise Anordnung der undotierten Bereiche in der Heteroübergangsschicht entsteht. Die vollständige unmittelbare Bedeckung der Tunnelschicht durch einen p- oder n-dotierten Bereich ist nach den Erkenntnissen des Anmelders hinsichtlich des Wirkungsgrades weniger relevant als die Unterbindung oder zumindest Verringerung der vorgenannten Verluste durch Zwischenschaltung der undotierten Bereiche jeweils zwischen einem p-dotierten und einem n-dotierten Bereich der Heteroübergangsschicht.

Die Solarzelle erfüllt nun erstmals die Anforderungen, dass eine rückseitenkontaktierte Silizium-Solarzelle eine hohe Offenklemmspannung ermöglicht und gleichzeitig im Vergleich zu vorbekannten Verfahren kostengünstig herstellbar ist. Diese Anforderungen konnten - trotz des großen Bedarfs an einer solchen Solarzellenstruktur für die industrielle Herstellung - mit den vorbekannten Strukturen und hierfür notwendigen Herstellungsverfahren nicht gedeckt werden.

Durch die vorgenannte vorzugsweise Ausführungsform des erfindungsgemäßen Verfahrens wird die Ausbildung der vorbeschriebenen Solarzellenstruktur mit einem hohen Wirkungsgrad insbesondere dadurch ermöglicht, dass durch den Wasserstoffeintrag in Verfahrensschritt D eine weiter verringerte Beeinträchtigung der Effizienz der Solarzelle, insbesondere der Offenklemmspannung, durch die undotierten Bereiche der Heteroübergangsschicht erfolgt.

Zur Ausbildung eines effizienten Hetero-Übergangs wird die Tunnelschicht unmittelbar auf das Halbleitersubstrat angeordnet.

Bevorzugt wird lateral, das heißt in einer Richtung parallel zur Rückseite der erfindungsgemäßen Solarzelle, jeder undotierte Bereich mit einer Breite im Bereich von 10 µm bis 1000 µm, bevorzugt im Bereich von 50 µm bis 500 µm ausgebildet. Die p- und n-dotierten Bereiche werden bevorzugt mit einer Breite im Bereich von 10 µm bis 1000 µm, insbesondere im Bereich 50 µm bis 500 µm ausgebildet.

Vorzugsweise wird auf der Heteroübergangsschicht eine metallische Kontaktierungsschicht angeordnet, welche Kontaktierungsschicht mit den p-dotierten Bereichen und den n-dotierten Bereichen elektrisch leitend verbunden und an den undotierten Bereichen unterbrochen ausgebildet ist.

Die Kontaktierungsschicht kann als Mehrschichtsystem ausgebildet werden und umfasst vorzugsweise eine oder mehrere Schichten aus einem oder mehreren der folgenden Materialien: Ni, Ti, Cu, Al, Ag oder Legierungen hiervon wie Beispielweise AlSi, TiN.

Diese derart ausgebildete Solarzelle weist weiterhin den Vorteil auf, dass an den undotierten Bereichen der Heteroübergangsschicht keine Kontaktbildung erfolgt. Es kann somit in einfacher und kostengünstiger Weise eine elektrische Kontaktierung einerseits der p-dotierten Bereiche und andererseits der n-dotierten Bereiche durch das Aufbringen einer Metallschicht, die jeweils im Oberflächenbereich der undotierten Bereiche unterbrochen ist, erfolgen. Auf diese Weise werden die p- und n-dotierten Bereiche vollständig von der Metallschicht überdeckt, ohne dass - wie bei den aus dem Stand der Technik bekannten Solarzellenstrukturen - die Gefahr eines Shunts, insbesondere eines Kurzschlusses, durch eine fehlerhafte Verbindung einer metallischen Kontaktierung mit einem entgegengesetzt dotierten Bereich der Heteroübergangsschicht riskiert wird.

Die vorzugsweise Ausführungsform des Verfahrens ermöglicht somit auch hinsichtlich der elektrischen Kontaktierung der p- und der n-dotierten Bereiche mittels einer Metallschicht eine Prozessvereinfachung und damit Kosteneinsparung, wobei gleichzeitig das Risiko von Wirkungsgrad minimierenden Shunts unterbunden oder zumindest verringert wird.

Es liegt dabei im Rahmen der Erfindung, dass die metallische Kontaktierungsschicht mittelbar auf der Heteroübergangsschicht angeordnet wird.

Ebenso liegt die Zwischenschaltung einer oder weiterer Schichten zwischen metallischer Kontaktierungsschicht und Heteroübergangsschicht im Rahmen der Erfindung, beispielsweise um die optische Güte, insbesondere die Reflexionseigenschaften der Rückseite der Solarzelle zu verbessern. Bevorzugt wird die metallische Kontaktierungsschicht lokal die vorgenannten zwischengeschalteten Schichten durchgreifend ausgebildet, um den elektrischen Kontakt zu den darunter liegenden n-dotierten Bereichen bzw. p-dotierten Bereichen herzustellen. Es ist somit im Gegensatz zu den vorbekannten Solarzellenstrukturen jedoch nicht notwendig, dass eine oder gegebenenfalls mehrere zwischengeschaltete Schichten eine hohe Sicherheit hinsichtlich der elektrischen Isolierung gewährleisten:
Bei den vorbekannten Solarzellenstrukturen besteht stets die Gefahr, dass eine über die Begrenzung des zugeordneten Dotierungsbereichs hinausragende Metallisierung, beispielsweise durch sogenanntes "Spiking" durch die zwischengelagerte Schicht hindurch den entgegengesetzt dotierten Bereich ebenfalls kontaktiert und es somit zu den vorgenannten Shunts und damit Wirkungsgradverlusten kommt.

Bei der vorbeschriebenen Solarzellenstruktur hingegen ist durch die zwischengeschalteten undotierten Bereiche ein "Puffer" gegeben, in welchem, wie zuvor beschrieben, die metallische Kontaktierungsschicht keinen elektrischen Kontakt ausbildet, sodass selbst in Bereichen, in denen die metallische Kontaktierungsschicht über den zugeordneten dotierten Bereich hinausragt, keinerlei Wirkungsgradverluste entstehen, da in solch einem hinausragenden Bereich die metallische Kontaktierungsschicht lediglich einen undotierten Bereich überdeckt, in welchem sich kein elektrischer Kontakt ausbildet. In der vorzugsweisen Ausführungsform mit einer oder mehrerer zwischengeschalteten Schichten zwischen Halbleitersubstrat und metallischer Kontaktierungsschicht kann somit eine Optimierung hinsichtlich anderer Eigenschaften, insbesondere hinsichtlich einer Verbesserung der optischen Güte erfolgen, ohne dass Rücksicht auf eine Ausgestaltung dieser Schicht zum Unterbinden eines Spiking genommen werden muss.

In einer vorzugsweisen Ausführungsform wird daher zwischen Heteroübergangsschicht und Kontaktierungsschicht zumindest eine dielektrische Schicht mit einem Brechungsindex im Bereich 1 bis 3 zumindest im Wellenlängenbereich 800 nm bis 1200 nm angeordnet, sodass die optische Güte der Rückseite der Solarzelle und damit die Lichtabsorption in der Solarzelle und letztendlich der Wirkungsgrad erhöht wird. Insbesondere ist es hierfür vorteilhaft, dass die dielektrische Schicht die Silizium ganzflächig bedeckt und lediglich lokal von der metallische Kontaktierungsschicht zur Kontaktierung der n-dotierten und p-dotierten Bereiche durchgriffen wird.

Die Heteroübergangsschicht kann in an sich bekannter Weise ausgebildet sein. Insbesondere liegt die Ausbildung der Heteroübergangsschicht als polykristalline, mikromorphe oder amorphe Heteroübergangsschicht im Rahmen der Erfindung. Die Heteroübergangsschicht kann als polykristalline Si-Schicht ausgebildet. Denn hierdurch ergibt sich der Vorteil, dass diese eine deutlich höhere elektrische Leitfähigkeit aufweist.

Mit dem erfindungsgemäßen Verfahren wird in einfacher und kostengünstiger Weise eine Solarzelle hergestellt, die die zuvor genannten Vorteile aufweist.

Insbesondere ist es vorteilhaft, die n- und p-dotierten Bereiche mittels Ionen-Implantation, insbesondere gerichteter Ionen-Implantation zu erzeugen. Hierdurch kann in kostengünstiger Weise ohne ein aufwendiges Aufbringen etwaiger Dotierstoff enthaltender Schichten als Dotierstoffquellen, mittels der lonenImplantation, die gewünschte Struktur von p- und n-dotierten Bereichen und zwischengeschalteten undotierten Bereichen erzeugt werden.

Eine besonders einfache und kostengünstige Herstellung ist hierbei möglich, indem die p- und/oder n-dotierten Bereiche, bevorzugt sowohl p- als auch n-dotierten Bereiche, mittels einer Schattenmaske erzeugt werden.

In einer alternativen Ausgestaltung des erfindungsgemäßen Verfahrens werden die p- und/oder n-dotierten Bereiche mittels einer Lackmaske erzeugt. Hierzu wird die Lackmaske jeweils in den Bereichen aufgebracht, in denen keine Dotierung erfolgen soll. Beispielsweise kann zunächst eine Lackmaske aufgebracht werden, die lediglich die p-dotierten Bereiche ausspart und anschließend erfolgt eine entsprechende Dotierung mittels Ionen-Implantation, wobei die Lackmaske als Barriere für die Ionen dient. Entsprechend wird die Lackmaske anschließend entfernt. Es erfolgt ein Anbringen einer weiteren Lackmaske, welche die zu erzeugenden n-dotierten Bereiche ausspart.

Insbesondere kostensparend ist hierbei das Aufbringen der Pasten mittels Siebdruck oder in einem Inkjet-Verfahren in an sich bekannter Weise.

Zur separaten Kontaktierung der p-dotierten Bereiche und der n-dotierten Bereiche andererseits ist die metallische Kontaktierungsschicht wie zuvor beschrieben an den undotierten Bereichen unterbrochen ausgebildet.

Vorzugsweise wird nach Verfahrensschritt D in einem Verfahrensschritt E' eine dielektrische Schicht auf die Heteroübergangsschicht aufgebracht und in einem Verfahrensschritt E" wird eine metallische Kontaktierungsschicht auf die dielektrische Schicht aufgebracht. Hierdurch kann, wie zuvor beschrieben, insbesondere die optische Güte der Rückseite der Solarzelle erhöht werden. Vorzugsweise ist daher die dielektrische Schicht auf die Heteroübergangsschicht vollständig deckend aufgebracht und die Kontaktierungsschicht wird derart aufgebracht, dass sie lediglich lokal die dielektrische Schicht durchgreift, um einen elektrischen Kontakt zu dem jeweils zugeordneten p- oder n-dotierten Bereich auszubilden. Die lokale Öffnung der dielektrischen Schicht kann mittels bekannter Verfahren wie Laserablation oder lokalem aufbringen von Ätzpasten erfolgen.

Zur Erhöhung der optischen Güte wird die vorgenannte dielektrische Schicht bevorzugt mit einem Brechungsindex im Bereich 1 bis 3 zumindest im Wellenlängenbereich 800 nm bis 1200 nm ausgebildet.

Die Dicke der vorgenannten dielektrischen Schicht liegt bevorzugt im Bereich 50 nm bis 1000 nm, insbesondere bevorzugt im Bereich 70 nm bis 400 nm.

Zwischen Verfahrensschritt E' und E" wird bevorzugt die dielektrische Schicht an jedem p- und jedem n-dotierten Bereich jeweils lokal geöffnet, um bei Durchgreifen der metallischen Kontaktierungsschicht eine elektrische Kontaktierung der jeweils zugeordneten dotierten Bereiche mit hoher Güte zu ermöglichen.

Zum Ausbilden der an den undotierten Bereichen unterbrochenen metallischen Kontaktierungsschicht ist es zum Erzielen eines kostengünstigen und unaufwendigen Herstellungsverfahrens vorteilhaft, dass die Kontaktierungsschicht an jedem zwischen einem p- und einem n-dotierten Bereich liegenden nicht dotierten Bereich entfernt wird. Dies kann wiederum durch bekannte Verfahren wie Laserablation oder durch lokales aufbringen von Ätzmedien geschehen.

Bevorzugt ist die Heteroübergangsschicht als kohlenstoffhaltige SiC-Schicht ausgebildet. Hierdurch ergibt sich der Vorteil, dass durch die Verwendung von kohlenstoffhaltige SiC-Schicht zum einen die Bandlücke und damit auch die optischen Eigenschaften verändert werden können. Des Weiten ist bekannt, dass SiC als Barriere für Kupfermigration geeignet ist und eine Oxidation der Schicht beim Einfahren in den Hochtemperaturschritt unterdrückt wird.

Bevorzugt ist die metallische Kontaktierungsschicht Kupfer enthaltend, insbesondere bevorzugt als Kupferschicht ausgebildet. Hierdurch ergibt sich der Vorteil, dass die Leitfähigkeit von Kupfer im Bereich deren von Silber liegt, jedoch deutlich günstiger ist.

Es liegt im Rahmen der Erfindung, mehrere, insbesondere zwei separate metallische Kontaktierungsstrukturen an der Rückseite der erfindungsgemäßen Solarzelle anzuordnen, sodass - wie bei vorbekannten Rückseiten-Kontaktstellen üblich - eine metallische Kontaktierungsstruktur die p-dotierten Bereiche und die andere metallische Kontaktierungsstruktur die n-dotierten Bereiche elektrisch kontaktiert und die beiden metallischen Kontaktierungsstrukturen entsprechend mit einem externen Stromkreis oder benachbarten Solarzellen in einer Modulverschaltung elektrisch verbunden werden können.

Insbesondere liegt es im Rahmen der Erfindung, dass die metallische Kontaktierungsstruktur für die p-dotierten Bereiche in einem separaten Verfahrensschritt zu dem Aufbringen der metallischen Kontaktierungsstruktur für die n-dotierten Bereiche aufgebracht wird und/oder dass für die zuerst genannte Kontaktierungsstruktur ein unterschiedliches Metall gegenüber der zweitgenannten Kontaktierungsstruktur verwendet wird. Zur Kontaktierung der p-dotierten Bereiche kann insbesondere eines oder mehrere der Metalle Cr, Ni, Al, Ag, Si, Ti verwendet werden. Zur Kontaktierung der n-dotierten Bereiche kann insbesondere eines oder mehrere der Metalle Cr, Ni, Al, Ag, Si, Ti verwendet werden.

Besonders vorteilhaft ist es jedoch, wie zuvor ausgeführt, eine metallische Kontaktierungsschicht anzuordnen, welche mit den p-dotierten Bereichen und den n-dotierten Bereichen elektrisch leitend verbunden und an den undotierten Bereichen unterbrochen ausgebildet ist. Auch hier wird somit eine metallische Kontaktierungsstruktur für die p-dotierten Bereiche ausgebildet, welche aufgrund der Unterbrechung an den undotierten Bereichen elektrisch isoliert zu der metallischen Kontaktierungsstruktur der n-dotierten Bereiche ausgebildet ist. Durch die Herstellung dieser beiden metallischen Kontaktierungsstrukturen ausgehend von einer metallischen Kontaktierungsschicht ist jedoch ein besonders einfacher und kostengünstiger Herstellungsprozess gegeben. In dieser vorzugsweisen Ausführungsform werden entsprechend p- und n-dotierte Bereiche mit der gleichen Metallschicht kontaktiert. Zur Kontaktierung beider Dotiertypen wird vorzugsweise eins der Metalle Al, AlSi, Ni, Ag verwendet.

Halbleitersubstrat ist vorzugsweise als Siliziumsubstrat, insbesondere als Siliziumwafer ausgeführt, insbesondere bevorzugt als monokristalliner Siliziumwafer. Ebenso liegt die Ausführung des Siliziumsubstrats als multikristalliner Siliziumwafer im Rahmen der Erfindung.

Die Dicke des Halbleitersubstrats liegt bevorzugt im Bereich 10 µm bis 300 µm
Die Dicke der Tunnelschicht liegt bevorzugt im Bereich 0.5 nm bis 3 nm.

Die p- oder n-dotierten Bereiche sind bevorzugt als langgestreckte, parallel verlaufende Bereiche ausgebildet, die sich in etwa über die gesamte Breite des Siliziumwafers erstrecken. Entsprechend sind auch die zwischengeordneten undotierten Bereiche vorzugsweise als langgestreckte, sich parallel zu den p- und n-dotierten Bereichen erstreckende Bereiche ausgebildet. Ebenso liegt die Ausbildung von sogenannten Punktdotierungen im Rahmen der Erfindung.

Die Tunnelschicht ist vorzugsweise als SiO₂ ausgebildet.

Vorzugsweise werden die n-dotierten Bereiche mittels Ionen-Implantation unter Verwendung von Phosphor und die p-dotierten Bereiche mittels lonenImplantation unter Verwendung von Bor erzeugt.

Das Halbleitersubstrat weist vorzugsweise eine Basisdotierung eines Basisdotierungstyps im Bereich von 10 ¹⁰10¹⁶ cm⁻³ auf. Vorzugsweise ist die Basis n-dotiert und entsprechend sind entgegengesetzt dotierte, das heißt p-dotierte Bereiche der Heteroübergangsschicht Emitterbereiche des Dotierungstyps. Ebenso liegt die umgekehrte Wahl der Dotierungstypen im Rahmen der Erfindung, das heißt das Ausbilden der Solarzelle mit einer p-Dotierung als Basisdotierungstyp und einer n-Dotierung als Emitter-Dotierungstyp.

Die Bereiche der Heteroübergangsschicht, welche den Basisdotierungstyp aufweisen, sind bevorzugt mit einer Dotierung im Bereich 10¹⁸ cm⁻¹ bis 10²¹cm⁻³ ausgebildet. Die Bereiche der Heteroübergangsschicht, welche den Emitterdotierungstyp aufweisen, sind bevorzugt mit einer Dotierung im Bereich 10¹⁸cm⁻³ bis 10²¹cm⁻³ ausgebildet.

Weitere vorzugsweisen Merkmale und Ausgestaltungen werden im Folgenden anhand von Ausführungsbeispielen und den Figuren erläutert.

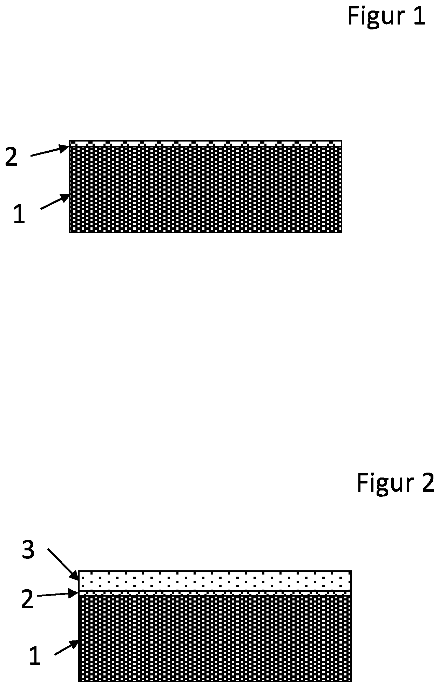

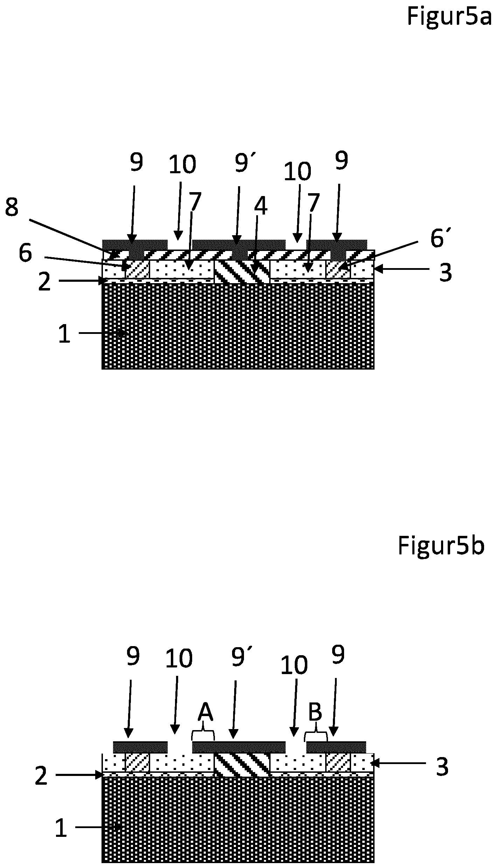

Dabei zeigen die Figuren 1 bis 5a ein Ausführungsbeispiel eines erfindungsgemäßen Verfahrens zum Herstellen einer photovoltaischen Solarzelle, wobei die Figur 5b eine lediglich als Beispiel gezeigte Alternative zur Ausbildung von metallischen Kontaktierungsstrukturen darstellt.

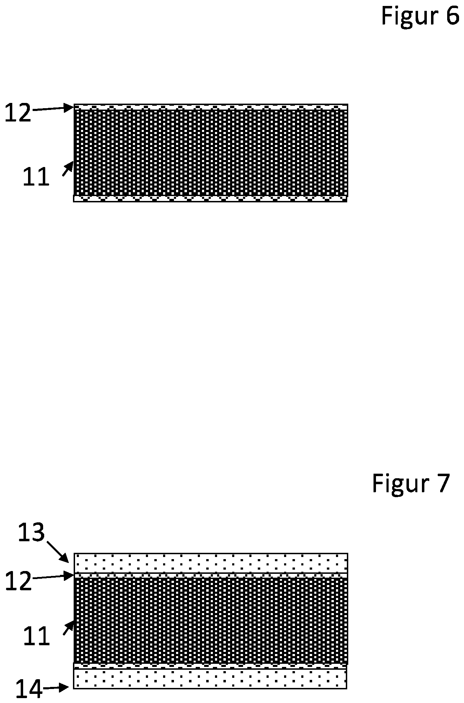

Figuren 6 bis 9 zeigen ein weiteres Ausführungsbeispiel eines erfindungsgemäßen Verfahrens, wobei eine homogen dotierte Heteroübergangsschicht ausgebildet wird.

In den Figuren sind jeweils schematische Schnittdarstellungen dargestellt, wobei zur besseren Übersicht Teilausschnitte dargestellt sind, das heißt die Solarzelle bzw. deren Vorstufe setzt sich nach rechts und links jeweils analog fort. In den Figuren bezeichnen gleiche Bezugszeichen gleiche oder gleichwirkende Elemente.

In dem in den Figuren dargestellten Ausführungsbeispiel eines erfindungsgemäßen Verfahrens wird gemäß Figur 1 auf ein als Siliziumsubstrat ausgebildetes Halbleitersubstrat 1 eine Tunnelschicht 2 aufgebracht. Das Halbleitersubstrat 1 ist als monokristalliner Siliziumwafer ausgebildet. Die Tunnelschicht 2 weist eine Dicke im Bereich 5 Angström bis 30 Angström, bevorzugt 10 Angström auf. Sie ist als Siliziumdioxidschicht ausgebildet. Ebenso kann die Tunnelschicht als ein andersartiges Oxid ausgebildet sein.

Die Tunnelschicht wird mittels nasschemischen Aufwachsen aufgebracht. Ebenso kann die Tunnelschicht mittels RTO (Rapid Thermal Oxidation), ALD (Atomic Layer Deposition), PECVD (Plasma Enhanced Chemical Vapor Deposition), LPCVD (Low Pressure Chemical Vapor Deposition) oder APCVD (Atmospheric Pressure Chemical Vapor Deposition) abgeschieden werden.

Figur 1 zeigt somit den Zustand, in welchem die Tunnelschicht unmittelbar auf die (in den Figuren 1 bis 5 oben liegend dargestellte) Rückseite des Halbleitersubstrates 1 aufgebracht wurde.

In einem weiteren Verfahrensschritt gemäß Figur 2 wird eine undotierte Heteroübergangsschicht 3 aufgebracht. Die Heteroübergangsschicht 3 kann als mikromorphe, amorphe oder polykristalline Heteroübergangsschicht ausgebildet sein.

Die Dicke der Heteroübergangsschicht liegt zwischen 10 nm und 1000 nm, bevorzugt bei etwa 30 nm. Die Heteroübergangsschicht wird mittels PECVD aufgebracht. Ebenso liegt das Aufbringen der Heteroübergangsschicht 3 mittels LPCVD oder APCVD oder Sputtern im Rahmen der Erfindung.

Figur 2 zeigt somit den Zustand, im welchen die undotierte Heteroübergangsschicht 3 unmittelbar auf die Tunnelschicht 2 aufgebracht wurde.

Um die Dotiereffizienz eines nachfolgenden Implantationsschrittes zu erhöhen, wird die polykristalline Heteroübergangsschicht 3 bevorzugt mit großen Körnern ausgebildet. Die Körner der polykristallinen Heteroübergangsschicht 3 weisen bevorzugt im Mittel einen Durchmesser größer 1 µm, bevorzugt größer 5 µm auf. Die Ausbildung einer polykristallinen Heteroübergangsschicht mit solchen Korngrößen ist an sich bekannt und beispielsweise im US 2010/0139764 A1, insbesondere Absatz [0023] beschrieben.

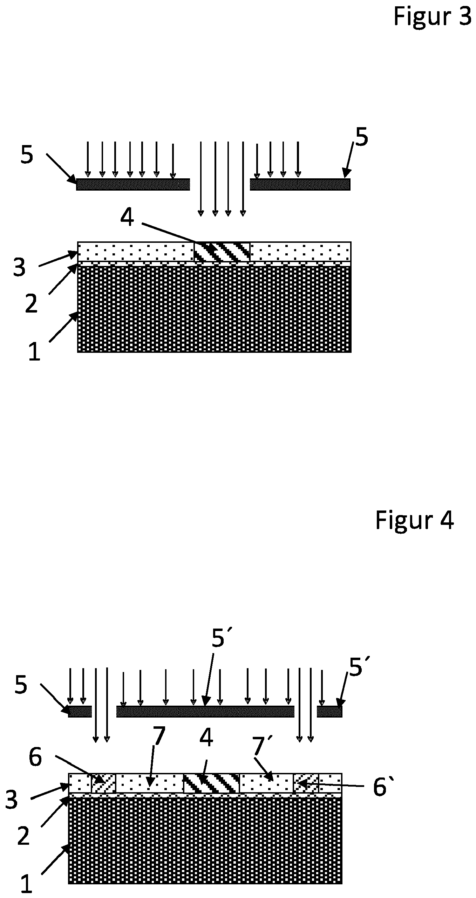

In einem weiteren Verfahrensschritt gemäß Figur 3 erfolgt ein lokales Dotieren der zuvor undotierten polykristallinen Heteroübergangsschicht 3 mit einer Dotierung eines Emitter-Dotierungstyp. Der Emitter-Dotierungstyp ist zu dem Basis-Dotierungstyp entgegengesetzt. Vorliegend ist das Halbleitersubstrat 1 n-dotiert. Die Basisdotierung ist somit eine n-Dotierung und entsprechend die Emitterdotierung eine p-Dotierung. Ebenso liegt es im Rahmen der Erfindung, umgekehrte Dotierungstypen zu wählen, das heißt eine p-dotierte Basis und einen n-dotierten Emitter.

In dem Verfahrensschritt gemäß Figur 3 werden somit p-dotierte Bereiche ausgebildet, wobei beispielhaft ein p-dotierter Bereich 4 dargestellt ist. Hierzu wird eine Schattenmaske 5 verwendet, welche beabstandet zur Heteroübergangsschicht 3 angeordnet ist. Die Pfeile in Figur 3 zeigen schematisch den lonenstrahl, welcher aufgrund der Schattenmaske nur in solchen Bereichen auf die Heteroübergangsschicht 3 auftrifft, in welchen der n-dotierte Bereich 4 mittels Ionen-Implantation erzeugt werden soll. Ebenso liegt es im Rahmen der Erfindung, anstelle der Schattenmaske 5 eine Lackmaske auf die Heteroübergangsschicht 3 aufzubringen, insbesondere bevorzugt mittels Siebdruck oder ein Inkjet-Verfahren.

Anschließend werden in einem Verfahrensschritt gemäß Figur 4 n-dotierte Bereiche mittels Ionen-Implantation erzeugt. Zur besseren Darstellbarkeit sind in Figur 4 lediglich zwei n-dotierte Bereiche 6 und 6' dargestellt.

Das Erzeugen der p-dotierten Bereiche erfolgt analog zu dem Vorgehen gemäß Figur 3: Mittels einer Schattenmaske 5' wird die Heteroübergangsschicht 3 hinsichtlich des lonenstroms abgedeckt, wobei lediglich solche Bereiche ausgespart bleiben, in welchen p-dotierte Bereiche 6, 6' erzeugt werden sollen.

Die n-dotierten Bereiche weisen somit den Basis-Dotierungstyp auf, sind jedoch höher dotiert als die Basis: Die Dotierung der n-dotierten Bereiche liegt hier im Bereich 10¹⁸cm⁻³ bis 10²¹ cm⁻³.

Figur 4 stellt somit den Zustand dar, in welchem eine Mehrzahl alternierend angeordneter p- und n-dotierter Bereiche in der Heteroübergangsschicht erzeugt wurde.

Anschließend erfolgt (nicht dargestellt) in einem Verfahrensschritt C ein Erhitzen der Solarzelle. Hierdurch wird eine Aktivierung der Dotierung und Auskristallisation der polykristallinen Heteroübergangsschicht 3 erzielt. Das Erhitzen stellt somit einen an sich bekannten Hochtemperaturschritt auf zumindest 600°C, vorliegend bei etwa 850°C dar. Der Hochtemperaturschritt wird in einem Rohrofen für eine Zeitdauer von ca. 60 Minuten durchgeführt. Ebenso kann der Hochtemperaturschritt als RTP-Schritt oder mittels eines Lasers durchgeführt werden. In diesem Hochtemperaturschritt kann der Dotierstoff innerhalb der Heteroübergangsschicht 3 diffundieren, sodass die p-dotierten Bereiche 4 und die n-dotierten Bereiche 6, 6' vollständig mit Dotierstoff ausgefüllt sind. Wesentlich ist jedoch, dass zwischengelagert zwischen den n-dotierten Bereichen und den p-dotierten Bereichen sich jeweils ein undotierter Bereich 7, 7' befindet.

Bei dem Hochtemperaturschritt kann Dotierstoff geringfügig durch die Tunnelschicht 2 diffundieren, ohne dass hierdurch der Wirkungsgrad der Solarzelle merkbar verändert wird. Bei geringer Qualität der Tunnelschicht ist auch eine Verbesserung des Wirkungsgrades möglich.

Anschließend wird (nicht dargestellt) gemäß Verfahrensschritt D Wasserstoff in die Heteroübergangsschicht 3 und an die Grenzfläche zwischen Tunnelschicht 2 und Halbleitersubstrat 1 eindiffundiert, vorliegend mittels Erwärmung auf 400°C für eine Zeitdauer von mindestens 1 min, bevorzugt 10 min, bevorzugt 30 min in einer stark wasserstoffhaltigen Atmosphäre (etwa 70 % H₂, der mittels eines MW-Plasma ionisiert wird).

Das Ausführungsbeispiel eines erfindungsgemäßen Verfahrens gemäß der Figuren 1 - 4 weist insbesondere den Vorteil auf, dass der Flächenanteil zwischen Emitter (p-dotierte Bereiche 4) und BSF (Back Surface Field), das heißt n-dotierten Bereichen 6, 6', und den undotierten Bereichen 7 und 7' auf der Rückseite der Solarzelle, das heißt innerhalb der Heteroübergangsschicht 3, frei wählbar ist und in einfacher Weise durch die Ausgestaltung der Schattenmasken 5 und 5' vorgegeben wird. Bei dem beschriebenen Verfahren trennen somit die undotierten Bereiche 7 und 7` jeweils die benachbarten hochdotierten Bereiche 4, 5, 5', sodass die Ladungsträger-Rekombination verringert wird.

Weiterhin bietet die ausgebildete Struktur mit den undotierten Bereichen 7, 7' einen weiteren wesentlichen Vorteil bei der nachfolgenden Metallisierung: Denn Silizium lässt sich nur dann elektrisch kontaktieren, wenn die Oberflächenkonzentration der Ladungsträger in Silizium einen Mindestwert überschreitet. Eine Metall-/Siliziumgrenzfläche zum undotierten Silizium führt zu einem sehr hohen Kontaktwiderstand und es kommt somit hinsichtlich einer praktischen Anwendung nicht zu einem elektrisch leitfähigen Kontakt. Wird somit beispielsweise die gesamte Rückseite der Heteroübergangsschicht 3 mit einer Metallschicht bedampft, so bilden sich elektrisch leitfähige Kontakte nur in den hochdotierten p-dotierten Bereichen 4 und n-dotierten Bereichen 6 und 6', nicht jedoch in den undotierten Bereichen 7 und 7'.

Hinsichtlich der Metallisierung, das heißt dem Ausbilden von metallischen Kontaktierungsstrukturen zur elektrischen Kontaktierung der p-dotierten Bereiche 4 einerseits und der n-dotierten Bereiche 6, 6' andererseits, können somit unterschiedliche Verfahrensschritte gewählt werden, wobei nachfolgend in den Figuren 5a und 5b zwei aus einer Mehrzahl von Alternativen beschrieben werden, wobei die Verfahrensschritte der Figur 5b nicht zur Erfindung gehören.

Gemäß Figur 5a wird zunächst eine dielektrische Schicht 8 mit einer Dicke im Bereich 10 nm bis 1000 nm, bevorzugt 70 nm bis 400 nm, vorliegend etwa 100 nm auf die Heteroübergangsschicht 3 aufgebracht. Diese dielektrische Schicht 8 wird in den p-dotierten Bereichen 4 und der n-dotierten Bereiche 6 und 6' lokal geöffnet (z.B. mittels Laserablation oder lokalen Ätzprozessen).

Die dielektrische Schicht 8 erfüllt insbesondere zwei Funktionen:
Wird die dielektrische Schicht 8 mit einem Brechungsindex 1 - 3 (zumindest im Wellenlängenbereich zwischen 800 nm und 1200 nm) ausgebildet, das heißt der Brechungsindex ist kleiner als der Brechungsindex des Halbleitersubstrates 1, sodass Photonen, die von der (in den Figuren unten dargestellten) Vorderseite in das Halbleitersubstrat eindringen, jedoch bei einem ersten Durchgang nicht absorbiert werden und somit über die Tunnelschicht 2 und die Heteroübergangsschicht 3 zu der dielektrischen Schicht 8 gelangen, wieder zurück in das Halbleitersubstrat 1 reflektiert werden. Die dielektrische Schicht 8 wirkt somit als optischer Spiegel für solche Photonen, sodass die Absorptionswahrscheinlichkeit und damit der Wirkungsgrad der Solarzelle erhöht werden.

Sofern für die nachfolgende Metallisierung Kupfer verwendet wird, wird die dielektrische Schicht 8 zusätzlich als Diffusionsbarriere ausgebildet, sodass eine für den Wirkungsgrad nachteilige Diffusion von Kupfer in den Halbleiter bzw. in die undotierten Bereiche 7, 7' der Heteroübergangsschicht 3 verhindert wird.

Aufgrund der besonderen Ausgestaltung und Anordnung der undotierten und dotierten Bereichen in der Heteroübergangsschicht 3 mittels des Verfahrens ist es jedoch nicht notwendig, dass die dielektrische Schicht elektrisch passivierend ist, denn die Passivierung der Rückseite des Halbleitersubstrates 1 erfolgt mittels der Tunnelschicht 2. Weiterhin kann die dielektrische Schicht 8 kleine Unterbrechungen, sogenannte Pinholes, aufweisen, da wie zuvor beschrieben, die undotierten Bereiche 7 und 7` keinen elektrischen Kontakt zu einer Metallschicht ausbilden.

Das beschriebene Verfahren bietet daher den Vorteil, da die vorgenannten Bedingungen der elektrischen Passivierung und des Vermeidens von Pinholes nicht erfüllt werden müssen, dass im Vergleich zu vorbekannten Verfahren eine größere Auswahl hinsichtlich der Ausgestaltung der dielektrischen Schicht 8 zur Verfügung steht. Insbesondere kann die dielektrische Schicht 8 aus Siliziumnitrid, Siliziumoxid, Titanoxid, Magnesiumfluorid, Aluminiumnitrid oder Aluminiumoxid ausgebildet werden. Aufgrund der geringeren Anforderungen steht auch eine breitere Auswahl an Verfahrensschritten bzw. Aufbringungsarten zum Erzeugen der dielektrischen Schicht 8 zur Verfügung.

Wie in Figur 5a weiterhin dargestellt, wird nach Aufbringen der dielektrischen Schicht 8 und lokalem Öffnen dieser dielektrischen Schicht 8 eine metallische Kontaktierungsschicht 9, 9' z.B. mittels Aufdampfen aufgebracht. Anschließend wird die Kontaktierungsschicht 9, 9' lokal in Bereichen 10 wieder entfernt, sodass die Kontaktierungsschicht 9, 9' an den undotierten Bereichen 7, 7' unterbrochen ausgebildet ist. Das lokale Entfernen erfolgt mittels Laserablation oder lokalen Ätzprozessen. Ebenso kann die Kontaktierungsschicht 9, 9' lokal mittels eines an sich bekannten Lift-off-Prozesses entfernt werden.

Es ergibt sich somit eine erste metallische Kontaktierungsstruktur umfassend die Bereiche 9 der Kontaktierungsschicht, welche die n-dotierten Bereiche 6 elektrisch kontaktiert. Weiterhin entsteht eine zweite metallische Kontaktierungsstruktur umfassend die Bereiche 9' der Kontaktierungsschicht, welche die p-dotierten Bereiche 4 elektrisch kontaktiert, wobei die Kontaktierungsstrukturen jeweils an den Bereichen, an denen die dielektrische Schicht 8 entfernt wurde, die darunter liegenden dotierten Bereiche berühren und elektrisch kontaktieren.

Figur 5a stellt somit den Zustand nach Durchführen eines Verfahrensschrittes E' dar, in welchem die dielektrische Schicht 8 auf die Heteroübergangsschicht 3 aufgebracht wird und nach einem Verfahrensschritt E", in welchem die metallische Kontaktierungsschicht 9, 9' auf die dielektrische Schicht 8 aufgebracht wird.

Figur 5b zeigt beispielhaft eine weitere Variante zur Ausbildung der elektrischen Kontaktierungsstrukturen, welche nicht zur Erfindung gehören. Im Gegensatz zu Figur 5a wird keine dielektrische Schicht aufgebracht, sondern lediglich eine Metallschicht 9, 9' ganzflächig abgeschieden und anschließend mittels Laserablation oder lokalen Ätzprozessen in den Bereichen 10 wieder entfernt. Es ergibt sich somit eine vergleichsweise kostengünstige Ausbildung metallischer Kontaktierungsstrukturen wie auch in Figur 5a, mit der Ausnahme, dass zwischen Kontaktierungsschicht 9, 9' und Heteroübergangsschicht 3 keine dielektrische Schicht zwischengelagert ist. Die Metallschicht wird mittels Aufdampfen aufgebracht. Insbesondere bei dieser Variante kommt der Vorteil zu tragen, dass in Überlappbereichen (zwei Überlappbereiche A und B sind exemplarisch in Figur 5b eingezeichnet), in welchen die Metallschicht nach der Strukturierung über die dotierten Bereiche hinausgeht, kein elektrischer Kontakt zu der darunter liegenden undotierten Heteroübergangsschicht 3 erfolgt. Eine Metallisierung gemäß Figur 5b stellt somit eine besonders einfache und kosteneffiziente Herstellungsvariante dar. Figur 5b zeigt somit den Zustand nach Durchführen eines Verfahrensschrittes E, in welchem auf die Heteroübergangsschicht 3 unmittelbar eine metallische Kontaktierungsschicht 9, 9' aufgebracht wird, welche lokal an den Bereichen 10 entfernt wurde.

Sofern die Metallisierung in der Variante gemäß Figur 5b erfolgt, ist es vorteilhaft, die polykristalline Heteroübergangsschicht 3 nicht als reine Heteroübergangsschicht, sondern beispielsweise als kohlenstoffhaltige SiC-Schicht auszubilden. Durch die Zugabe von beispielsweise Kohlenstoff lässt sich die Bandlücke der polykristallinen Heteroübergangsschicht 3 vergrößern und somit auch deren Brechungsindex, zumindest im Wellenlängenbereich zwischen 800 nm und 1200 nm verringern, sodass ein effizienter optischer Spiegel ausgebildet wird mit den bereits vorgenannten Vorteilen. Weiterhin ist die Diffusion von Kupfer in SiC deutlich geringer als in Silizium, sodass eine Migration von Kupfer in die Raumladungszone des pn-Übergangs der Solarzelle verhindert werden kann.

Die Kontaktierungsschicht 9, 9' wird gemäß Figur 5b zunächst vollflächig aufgebracht und anschließend strukturiert. Ebenso werden die dielektrische Schicht 8 und die Kontaktierungsschicht 9, 9' gemäß Figur 5a zunächst vollflächig aufgebracht und anschließend jeweils strukturiert.

Die Figuren 5a und 5b zeigen somit jeweils eine Solarzelle, welche wie zuvor beschrieben das Halbleitersubstrat 1 mit einer auf der (oben dargestellten) Rückseite des Halbleitersubstrates 1 unmittelbar angeordneten Tunnelschicht 2 und auf der Tunnelschicht 2 unmittelbar angeordneten Heteroübergangsschicht 3. Die Heteroübergangsschicht 3 weist eine Mehrzahl alternierend angeordneter n- (6, 6') und p- (4) dotierter Bereiche auf. Wesentlich ist, dass in der Heteroübergangsschicht 3 zwischen den n-dotierten Bereichen (6, 6') und p-dotierten Bereichen (4) jeweils ein undotierter Bereich (7, 7`) angeordnet ist.

Die derart ausgebildete Solarzelle weist vorzugsweise eine durchgehende Heteroübergangsschicht 3 auf, das heißt bevorzugt eine sich im Wesentlichen über die gesamte Rückseite der Solarzelle erstreckende, ununterbrochene Heteroübergangsschicht 3. Hierdurch wird die rückseitige Oberfläche des Halbleitersubstrates 1 durchgehend elektrisch passiviert (das heißt die Oberflächenrekombinationsgeschwindigkeit ist gering) und gegenüber Verunreinigungen und anderer negativer Einwirkungen geschützt. Weiterhin ist von Vorteil, dass die Metallisierungen 9, 9' auf einer Ebene liegen und nicht etwa einen Stufenversatz zueinander aufweisen, sodass in solchen Stufen begründete Probleme bei Verschaltung der Solarzelle bzw. Verbinden mit einem externen Stromkreis oder benachbarter Solarzellen in einem Solarzellenmodul vermieden werden.

In dem in den Figuren 6 bis 9 dargestellten weiteren Ausführungsbeispiel eines erfindungsgemäßen Verfahrens wird gemäß Figur 6 auf ein als Siliziumsubstrat ausgebildetes Halbleitersubstrat 11 eine Tunnelschicht 12 aufgebracht. Das Halbleitersubstrat 11 ist als monokristalliner Siliziumwafer ausgebildet. Die Tunnelschicht 12 weist eine Dicke im Bereich 5 Angström bis 30 Angström, bevorzugt 10 Angström auf. Sie ist als Siliziumdioxidschicht ausgebildet. Ebenso kann die Tunnelschicht als ein andersartiges Oxid ausgebildet sein.

Die Tunnelschicht wird mittels mittels nasschemischen Aufwachsen aufgebracht. Ebenso kann die Tunnelschicht mittels RTO (Rapid Thermal Oxidation) oder ALD (Atomic Layer Deposition), PECVD, LPCVD oder APCVD abgeschieden werden.

Figur 6 zeigt somit den Zustand, in welchem die Tunnelschicht unmittelbar auf Vorder- und Rückseite des Halbleitersubstrates 11 aufgebracht wurde.

In einem weiteren Verfahrensschritt gemäß Figur 7 wird eine n-dotierte Heteroübergangsschicht 13 und anschließend eine p-dotierte Heteroübergangsschicht 14 aufgebracht. Die Heteroübergangsschichten 13 und können als mikromorphe, amorphe oder polykristalline Heteroübergangsschicht ausgebildet sein. Wahlweise kann auch Schicht 13 p-dotiert sein und Schicht 14 ist n-dotiert. Auch ist die Abscheidung von intrinsischen Schichten und nachträglicher Implantation von Bor bzw. Phosphor möglich.

Die Dicke der Heteroübergangsschicht liegt zwischen 10 nm und 1000 nm, bevorzugt bei etwa 30 nm. Die Heteroübergangsschicht wird mittels PECVD aufgebracht. Ebenso liegt das Aufbringen der Heteroübergangsschichten 13 und 14 mittels LPCVD oder APCVD oder Sputtern im Rahmen der Erfindung. Bei Verwendung der Verfahren LPCVD bzw. APCVD ist eine beidseitige Abscheidung unumgänglich und somit ist es besonders vorteilhaft eine undotierte Schicht abzuscheiden und diese nachträglich mittels lonenimplantation zu dotieren.

Anschließend erfolgt (nicht dargestellt) in einem Verfahrensschritt C ein Erhitzen der Solarzelle. Hierdurch kann eine Aktivierung der Dotierung und Auskristallisation der Heteroübergangsschicht 13 und 14 erzielt werden. Das Erhitzen stellt somit einen an sich bekannten Hochtemperaturschritt, bevorzugt mit Temperaturen im Bereich 600-900°C dar. Der Hochtemperaturschritt wird in einem Rohrofen durchgeführt. Ebenso kann der Hochtemperaturschritt als RTP-Schritt oder mittels eines Lasers durchgeführt werden.

Bei dem Hochtemperaturschritt kann Dotierstoff geringfügig durch die Tunnelschicht 12 diffundieren, ohne dass hierdurch der Wirkungsgrad der Solarzelle merkbar verändert wird.

Anschließend erfolgt in einem Verfahrensschritt D die Wasserstoffpassivierung (nicht dargestellt), um die Passiviereigenschaften zu verbessern.

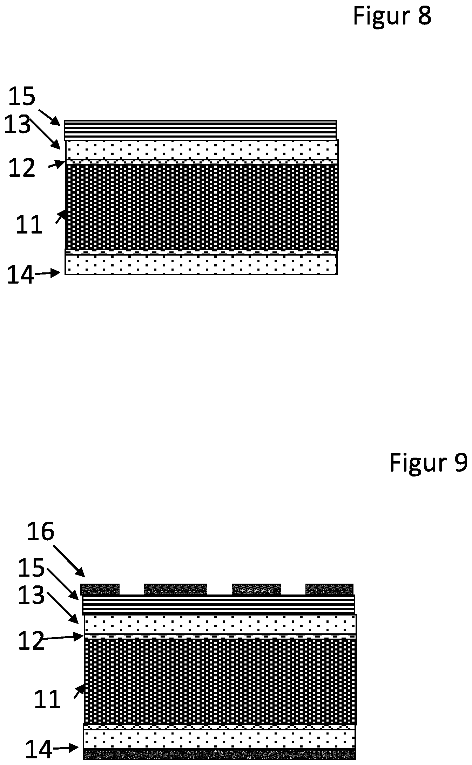

In einem weiteren Verfahrensschritt gemäß Figur 8 wird eine TCO-Schicht 15 aufgebracht. Diese TCO-Schicht dient zur Herstellung der Querleitfähigkeit sowie zur besseren Einkopplung des einfallenden Lichts. Diese Schicht 15 kann als ITO, AZO, IO:H ausgebildet sein und ist ca. 70 nm dick. Wahlweise kann auch Schicht 15 kein TCO, sondern eine µc-SiC:H-Schicht sein. Diese bietet den o.g. Vorteil, dass sie Wasserstoff spendet, für eine gewisse Querleitfähigkeit sorgt und geringe Absorption aufweist. Die Güte dieser Schicht ist aber nicht mit einem TCO vergleichbar.

In einem weiteren Verfahrensschritt gemäß Figur 9 wird eine Metallschicht 16 vorderseitig in Form eines Kontaktierungsgitters und rückseitig ganzflächig eine Metallschicht aufgebracht.

## Patentansprüche

1. Verfahren zum Herstellen einer photovoltaischen Solarzelle mit zumindest einem Heteroübergang, welcher eine Tunnelschicht aufweist, umfassend folgende Verfahrensschritte:
A Bereitstellen eines Halbleitersubstrats (1,11) mit einer Basisdotierung;
B Erzeugen eines Heteroübergangs an zumindest einer Seite des Halbleitersubstrates, welcher Heteroübergang eine dotierte Heteroübergangsschicht und eine unmittelbar zwischen Heteroübergangsschicht (3,14) und Halbleitersubstrat angeordnete dielektrische Tunnelschicht (2) aufweist,
wobei die Heteroübergangsschicht mit einer Dicke im Bereich 10 nm bis 1000 nm ausgebildet wird;
C Erwärmen zumindest der Heteroübergangsschicht zum Verbessern der elektrischen Güte des Heteroübergang;
**dadurch gekennzeichnet,**
**dass** in Verfahrensschritt C ein Erwärmen zumindest der Heteroübergangsschicht auf zumindest 600° Celsius erfolgt,
**dass** in einem Verfahrensschritt D nach Verfahrensschritt C Wasserstoff in die Heteroübergangsschicht und/oder an die Grenzfläche zwischen Tunnelschicht und Halbleitersubstrat eindiffundiert wird, wobei in Verfahrensschritt D die Solarzelle auf zumindest 350°C erwärmt wird
und **dass** auf der Heteroübergangsschicht mittelbar eine metallische Kontaktierungsschicht (9,9') angeordnet wird, welche elektrisch leitend mit der Heteroübergangsschicht zur Ausbildung einer Kontaktierung verbunden wird.

2. Verfahren nach Anspruch 1,
**dadurch gekennzeichnet,**
**dass** in Verfahrensschritt D nach Verfahrensschritt C Wasserstoff sowohl an die Grenzfläche zwischen Tunnelschicht und Halbleitersubstrat, als auch in die Heteroübergangsschicht eindiffundiert wird.

3. Verfahren nach einem der vorangegangenen Ansprüche,
**dadurch gekennzeichnet,**
**dass** die Heteroübergangsschicht als Silizium haltige Schicht ausgebildet wird.

4. Verfahren nach einem der vorangegangenen Ansprüche,
**dadurch gekennzeichnet,**
**dass** die Heteroübergangsschicht als kohlenstoffhaltige SiC-Schicht ausgebildet wird.

5. Verfahren nach einem der vorangegangenen Ansprüche, **dadurch gekennzeichnet,**
**dass** die Heteroübergangsschicht in Verfahrensschritt B als amorphe Siliziumhaltige Schicht ausgebildet wird und
**dass** in den Verfahrensschritten C und D die amorphe Struktur der Heteroübergangsschicht erhalten wird, indem keine Erwärmung der Heteroübergangsschicht auf über 800°C erfolgt.

6. Verfahren nach einem der vorangegangenen Ansprüche, **dadurch gekennzeichnet,**
**dass** in den Verfahrensschritten C und D ein Eindiffundieren von Dotierstoff aus der Heteroübergangsschicht in das Halbleitersubstrat vermieden wird, indem keine Erwärmung der Heteroübergangsschicht auf über 800°C erfolgt.

7. Verfahren nach einem der vorangegangenen Ansprüche, **dadurch gekennzeichnet,**
**dass** in Verfahrensschritt D der Wasserstoff mittels RPHP eingebracht wird.

8. Verfahren nach einem der Ansprüche 1 bis 5,
dass der Wasserstoff eingebracht wird, indem eine wasserstoffhaltige Schicht mittelbar oder unmittelbar auf die Heteroübergangsschicht aufgebracht und anschließend mittels Erwärmung der Wasserstoff eingebracht wird.

9. Verfahren nach Anspruch 8,
**dadurch gekennzeichnet,**
**dass** die wasserstoffhaltige Schicht als mikrokristalline Siliziumschicht ausgebildet wird.

10. Verfahren nach Anspruch 8
**dadurch gekennzeichnet,**
**dass** die wasserstoffhaltige Schicht als Siliziumnitridschicht ausgebildet wird.

11. Verfahren nach Anspruch 8
**dadurch gekennzeichnet,**
**dass** in Verfahrensschritt D ein Erwärmen auf eine Temperatur im Bereich 700°C bis 900°C für eine Zeitdauer im Bereich 0,5 s bis 20 s erfolgt.

12. Verfahren nach einem der vorangegangenen Ansprüche,
**dadurch gekennzeichnet,**
**dass** Verfahrensschritt C in Stickstoffatmosphäre durchgeführt wird.

13. Verfahren nach einem der vorangegangenen Ansprüche,
**dadurch gekennzeichnet,**
**dass** in der Heteroübergangsschicht eine Mehrzahl alternierend angeordneter p- und n-dotierter Bereiche ausgebildet werden, wobei die p- und n-dotierten Bereiche jeweils beabstandet voneinander erzeugt werden, sodass zwischen benachbarten p- und n-dotierten Bereichen jeweils ein nicht dotierter Bereich der Heteroübergangsschicht angeordnet ist.

## Claims

1. Method for producing a photovoltaic solar cell having at least one heterojunction which has a tunnel layer, comprising the following method steps:
A providing a semiconductor substrate (1, 11) having base doping;
B generating a heterojunction on at least one side of the semiconductor substrate, which heterojunction has a doped heterojunction layer and a dielectric tunnel layer (2) arranged directly between the heterojunction layer (3, 14) and the semiconductor substrate,
the heterojunction layer being configured with a thickness in the range of from 10 nm to 1000 nm;
C heating at least the heterojunction layer in order to improve the electrical quality of the heterojunction;
**characterised in that**
in method step C, at least the heterojunction layer is heated to at least 600°C;
in a method step D after method step C, hydrogen is diffused into the heterojunction layer and/or to the interface between the tunnel layer and the semiconductor substrate, wherein in method step D the solar cell is heated to at least 350°C;
and a metal contacting layer (9, 9') is arranged indirectly on the heterojunction layer, which metal contacting layer is electrically conductively connected to the heterojunction layer to form a contact.

2. Method according to claim 1,
**characterised in that**
in method step D after method step C, hydrogen is diffused both to the interface between the tunnel layer and the semiconductor substrate and into the heterojunction layer.

3. Method according to either one of the preceding claims,
**characterised in that**
the heterojunction layer is formed as a silicon-containing layer.

4. Method according to any one of the preceding claims,
**characterised in that**
the heterojunction layer is formed as a carbon-containing SiC layer.

5. Method according to any one of the preceding claims,
**characterised in that**
the heterojunction layer in method step B is formed as an amorphous silicon-containing layer; and
in method steps C and D the amorphous structure of the heterojunction layer is retained by not heating the heterojunction layer to more than 800°C.

6. Method according to any one of the preceding claims,
**characterised in that**
in method steps C and D, diffusion of dopant from the heterojunction layer into the semiconductor substrate is avoided by not heating the heterojunction layer to more than 800°C.

7. Method according to any one of the preceding claims,
**characterised in that**
in method step D, the hydrogen is introduced by means of RPHP.

8. Method according to any one of claims 1 to 5,
**characterised in that**
the hydrogen is introduced by applying a hydrogen-containing layer indirectly or directly to the heterojunction layer and then introducing the hydrogen by means of heating.

9. Method according to claim 8,
**characterised in that**
the hydrogen-containing layer is formed as a microcrystalline silicon layer.

10. Method according to claim 8,
**characterised in that**
the hydrogen-containing layer is formed as a silicon nitride layer.

11. Method according to claim 8,
**characterised in that**
in method step D, heating to a temperature in the range of from 700°C to 900°C is carried out for a period in the range of from 0.5 s to 20 s.

12. Method according to any one of the preceding claims,
**characterised in that**
method step C is carried out in a nitrogen atmosphere.

13. Method according to any one of the preceding claims,
**characterised in that**
a plurality of alternately arranged p-doped and n-doped regions are formed in the heterojunction layer, the p-doped and n-doped regions each being created spaced apart from one another, so that a non-doped region of the heterojunction layer is arranged between adjacent p-doped and n-doped regions.

## Revendications

1. Procédé de fabrication d'une cellule solaire photovoltaïque comprenant au moins une hétérojonction, laquelle présente une couche tunnel, comprenant des étapes de procédé suivantes :
A fournir un substrat semi-conducteur (1, 11) comprenant un dopage de base ;
B générer une hétérojonction au moins d'un côté du substrat semi-conducteur, laquelle hétérojonction présente une couche dopée d'hétérojonction et une couche tunnel (2) diélectrique disposée directement entre la couche d'hétérojonction (3, 14) et le substrat semi-conducteur,
dans lequel la couche d'hétérojonction est réalisée avec une épaisseur dans la plage de 10 nm à 1000 nm ;
C chauffer au moins la couche d'hétérojonction pour améliorer la qualité électrique de l'hétérojonction ;
**caractérisé en ce que**
à l'étape de procédé C, un chauffage de la couche d'hétérojonction au moins à au moins 600 °C est effectué,
à une étape de procédé D, après l'étape de procédé C, de l'hydrogène est diffusé dans la couche d'hétérojonction et/ou sur la surface limite entre la couche tunnel et le substrat semi-conducteur, dans lequel à l'étape de procédé D, la cellule solaire est chauffée à au moins 350 °C, et
est disposée indirectement sur la couche d'hétérojonction une couche de contact métallique (9, 9'), laquelle est reliée de manière électriquement conductrice à la couche d'hétérojonction pour réaliser une mise en contact.

2. Procédé selon la revendication 1, **caractérisé en ce que**
à l'étape de procédé D, après l'étape de procédé C, de l'hydrogène est diffusé à la fois sur la surface limite entre la couche de tunnel et le substrat semi-conducteur et dans la couche d'hétérojonction.

3. Procédé selon l'une des revendications précédentes,
**caractérisé en ce que**
la couche d'hétérojonction est réalisée en tant qu'une couche contenant du silicium.

4. Procédé selon l'une des revendications précédentes,
**caractérisé en ce que**
la couche d'hétérojonction est réalisée en tant qu'une couche carbonée de SiC.

5. Procédé selon l'une des revendications précédentes,
**caractérisé en ce que**
la couche d'hétérojonction est réalisée à l'étape de procédé B en tant qu'une couche amorphe contenant du silicium, et
aux étapes de procédé C et D, la structure amorphe de la couche d'hétérojonction est obtenue, tandis qu'aucun chauffage de la couche d'hétérojonction au-dessus de 800 °C n'est effectué.

6. Procédé selon l'une des revendications précédentes,
**caractérisé en ce que**
aux étapes de procédé C et D, une diffusion d'agent de dopage depuis la couche d'hétérojonction dans le substrat semi-conducteur est évitée, tandis qu'aucun chauffage de la couche d'hétérojonction au-dessus de 800 °C n'est effectué.

7. Procédé selon l'une des revendications précédentes,
**caractérisé en ce que**
à l'étape de procédé D, l'hydrogène est introduit par RPHP.

8. Procédé selon l'une des revendications 1 à 5,
**caractérisé en ce que**
l'hydrogène est introduit, tandis qu'une couche contenant de l'hydrogène est appliquée indirectement ou directement sur la couche d'hétérojonction puis l'hydrogène est introduit par chauffage.

9. Procédé selon la revendication 8,
**caractérisé en ce que**
la couche contenant de l'hydrogène est réalisée en tant que couche de silicium microcristallin.

10. Procédé selon la revendication 8,
**caractérisé en ce que**
la couche contenant de l'hydrogène est réalisée en tant que couche de nitrure de silicium.

11. Procédé selon la revendication 8,
**caractérisé en ce que**
à l'étape de procédé D, un chauffage à une température dans la plage de 700 °C à 900 °C pendant une durée dans la plage de 0,5 s à 20 s est effectué.

12. Procédé selon l'une des revendications précédentes,
**caractérisé en ce que**
l'étape de procédé C est mise en oeuvre sous atmosphère azotée.

13. Procédé selon l'une des revendications précédentes,
**caractérisé en ce que**
une multitude de zones dopées P et N disposées de manière alternée sont réalisées dans la couche d'hétérojonction, dans lequel les zones dopées P et N sont générées respectivement de manière espacée les unes des autres à tel point qu'une zone non dopée de la couche d'hétérojonction est disposée respectivement entre des zones dopées P et N voisines.
